# EUROPEAN PATENT APPLICATION

(11) **EP 2 302 700 A1**
(43) Date of publication of application: **30.03.2011**
(21) Application number: 09773562.5
(22) Date of filing: 26.06.2009
(51) Int. Cl.: H01L 31/10, H01L 51/42

(54) **ORGANIC PHOTOELECTRIC CONVERSION ELEMENT**

(30) Priority: 30.06.2008 JP 2008170240; 15.01.2009 JP 2009006349
(71) Applicant: Sumitomo Chemical Company, Limited, Tokyo 104-8260 (JP)
(72) Inventor: UETANI, Yasunori, Tsukuba-shi Ibaraki 305-0045 (JP); NOGUCHI, Takanobu, Tsukuba-shi Ibaraki 305-0065 (JP)
(74) Representative: Vossius & Partner
(86) International application number: PCT/JP2009/062172
(87) International publication number: WO 2010/001984

(57) **Abstract**

An organic photoelectric conversion element having a pair of electrodes and a functional layer arranged between the electrodes, wherein the functional layer contains an electron-accepting compound and a polymer having a repeating unit which is composed of a structure represented by formula (1) and a structure represented by formula (2): 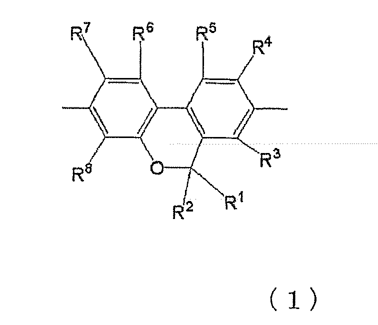 (wherein R¹ to R⁸ may be the same or different, and each represents a hydrogen atom, an alkyl group, an alkoxy group, or an optionally substituted aryl group; and a hydrogen atom contained in the groups may be substituted by a fluorine atom.) 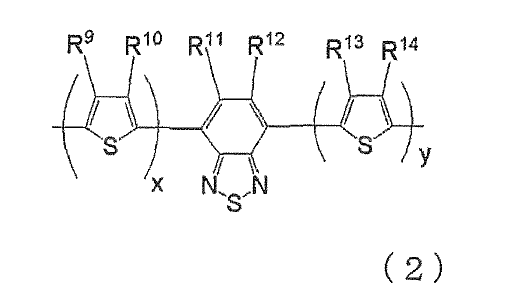 (wherein R⁹ to R¹⁴ may be the same or different, and each represents a hydrogen atom, an alkyl group, an alkoxy group, or an optionally substituted aryl group; and a hydrogen atom contained in the groups may be substituted by a fluorine atom; x and y may be the same or different, and each represents 1 or 2: and when there are a plurality of R⁹' s, R¹⁰' s, R¹³' s or R¹⁴' s, the R⁹' s, R¹⁰' s, R¹³' s or R¹⁴' s may be the same as or different from each other, respectively.)

## Description

### TECHNICAL FIELD

The invention relates to an organic photoelectric conversion element.

### BACKGROUND ART

An organic semiconductor material having a charge (electron, hole) transporting characteristic is expected to be applied to an organic photoelectric conversion element (an organic solar battery, an optical sensor, or the like). In order to improve various characteristics of the element, the organic photoelectric conversion element containing a polymer that can be various organic semiconductor materials has been examined.

More specifically, an organic photoelectric conversion element having a layer that contains a polyfluorene copolymer composed of a fluorenediyl group and a benzothiazolediyl group, represented by the following formula, is known (Applied Physics Letters Vol. 90, No. 14 143506 (2007).

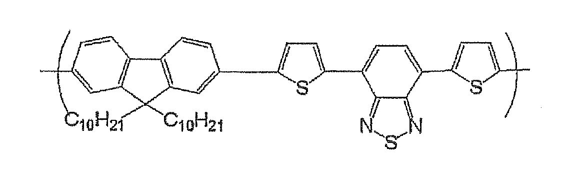

### DISCLOSURE OF THE INVENTION

However, the above-mentioned organic photoelectric conversion element does not necessarily provide high photoelectric conversion efficiency.

The objective of the present invention is to provide an organic photoelectric conversion element having high photoelectric conversion efficiency.

First, the present invention provides an organic photoelectric conversion element comprsing:
a pair of electrodes and a functional layer placed between the electrodes, the functional layer containing an electron-accepting compound and a polymer, wherein the polymer has a repeating unit that is composed of a structure represented by formula (1) and a structure represented by formula (2): 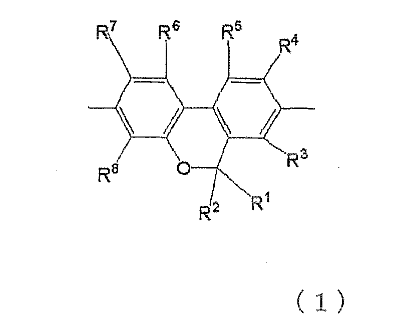 (wherein R¹ to R⁸ may be the same or different, and each represents a hydrogen atom, an alkyl group, an alkoxy group, or an optionally substituted aryl group; and a hydrogen atom contained in the groups may be substituted by a fluorine atom.) 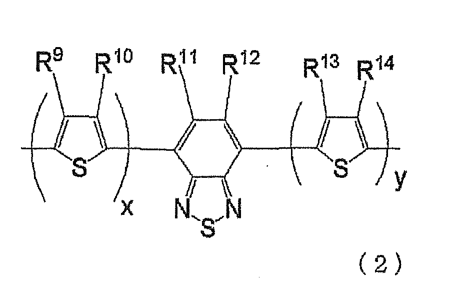
(wherein R⁹ to R¹⁴ may be the same or different, and each represents a hydrogen atom, an alkyl group, an alkoxy group, or an optionally substituted aryl group; and a hydrogen atom contained in the groups may be substituted by a fluorine atom; x and y may be the same or different and are 1 or 2; and when there are a plurality of R⁹' s, R¹⁰' s, R³¹' s or R¹⁴' s respectively, the groups may be the same or different from each other.)

Second, the present invention provides an organic photoelectric conversion element, wherein the ratio of the electron-accepting compound in the functional layer is set to 10 to 1000 parts by weight relative to 100 parts by weight of the polymer.

Third, the present invention provides an organic photoelectric conversion element comprising:
a pair of electrodes; a functional layer and an organic layer that are placed between the electrodes, the organic layer containing an electron-accepting compound, wherein the functional layer contains a polymer having a repeating unit that is composed of a structure represented by formula (1) and a structure represented by formula (2), and the organic layer and the functional layer are made in contact with each other: 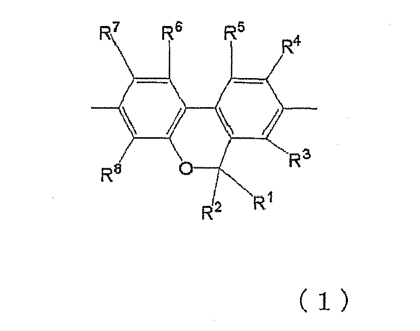 (wherein R¹ to R⁸ may be the same or different, and each represents a hydrogen atom, an alkyl group, an alkoxy group, or an optionally substituted aryl group; and a hydrogen atom contained in the groups may be substituted by a fluorine atom.) 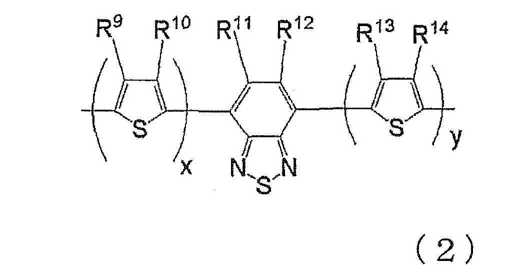 (wherein R⁹ to R¹⁴ may be the same or different, and each represents a hydrogen atom, an alkyl group, an alkoxy group, or an optionally substituted aryl group; and a hydrogen atom contained in the groups may be substituted by a fluorine atom; x and y may be the same or different and are 1 or 2; and when there are a plurality of R⁹' s, R¹⁰' s, R¹³' s or R¹⁴' s respectively, the groups may be the same or different from each other.)

Fourth, the present invention provides an organic photoelectric conversion element, wherein the electron-accepting compound is a fullerene derivative.

### MODE FOR CARRYING OUT THE INVENTION

The present invention will be explained in detail below.

### <Polymer>

The polymer to be used in the present invention contains a repeating unit composed of a structure represented by formula (1) and a structure represented by formula (2).

### • Structure represented by formula (1)

In formula (1), R¹, R², R³, R⁴, R⁵, R⁶, R⁷ and R⁸ may be the same or different, and each represents an alkyl group, an alkoxy group, or an optionally substituted aryl group.

When each of R¹, R², R³, R⁴, R⁵, R⁶, R⁷ and R⁸ is an alkyl group or an alkoxy group, the number of carbon atoms is preferably 1 to 20, more preferably 2 to 18, much more preferably 3 to 12 from the viewpoint of solubility of the polymer to a solvent.

The alkyl group represented by R¹ to R⁸ preferably has carbon atoms of 1 to 20. Examples of the alkyl group include a methyl group, an ethyl group, an n-propyl group, an isoprupyl group, an n-butyl group, an isobutyl group, an s-butyl group, a t-butyl group, an n-pentyl group, an n-hexyl group, an n-octyl group, an isooctyl group, an n-decyl group, an n-dodecyl group, an n-pentadecyl group and an n-octadecyl group. In the alkyl group, a hydrogen atom in one portion or the entire portion thereof may be substituted by a fluorine atom.

The alkoxy group represented by R¹ to R⁸ preferably has carbon atoms of 1 to 20. Examples of the alkoxy group include a methoxy group, an ethoxy group, an propyloxy group, an i-propyloxy group, a butoxy group, an i-butoxy group, an s-butoxy group, a t-butoxy group, a pentyloxy group, a hexyloxy group, a cyclohexyloxy group, a heptyloxy group, an octyloxy group, a 2-ethylhexyloxy group, a nonyloxy group, a decyloxy group and a 3,7-dimethyloctyloxy group. In the alkoxy group, hydrogen atoms in one portion or the entire portion thereof may be substituted by a fluorine atom.

The optionally substituted aryl group represented by R¹ to R⁸ preferably has carbon atoms of 6 to 60, more preferably 6 to 30. Examples of the aryl group include a phenyl group, a 1-naphthyl group and a 2-naphtyl group. Examples of the substituent possessed by the aryl group include a halogen atom, an alkyl group and an alkoxy group.

Specific examples of the structure represented by formula (1) include the following structures:

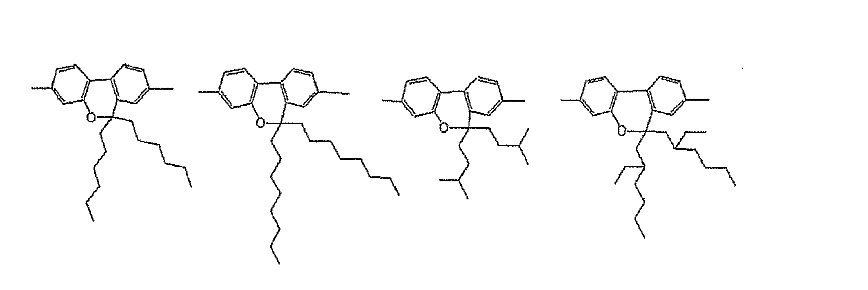

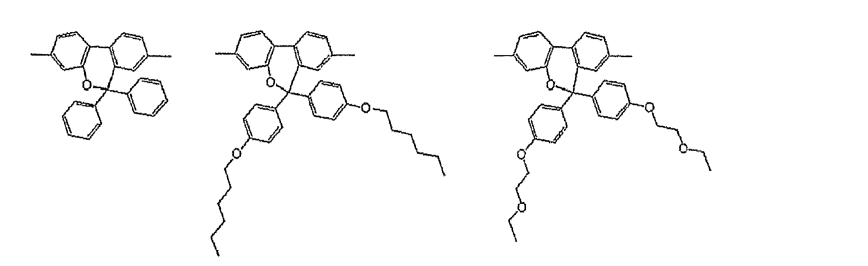

The polymer to be used in the present invention may contain one kind or two or more kinds of structures represented by formula (1). • Structure represented by formula (2) .

In formula (2), examples of the alkyl group represented by R⁹ to R¹⁴ are the same group as the alkyl group represented by the aforementioned R¹.

In formula (2), examples of the alkoxy group represented by R⁹ to R¹⁴ are the same group as the alkoxy group represented by the aforementioned R¹.

In formula (2), examples of the optionally substituted aryl group that is represented by R⁹ to R¹⁴ are the same group as the optionally substituted aryl group that is represented by the aforementioned R¹.

Specific examples of the structure represented by formula (2) include the following structures:

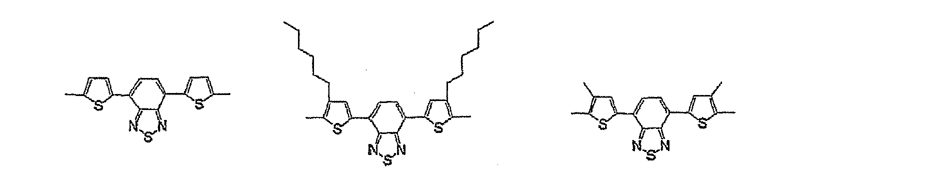

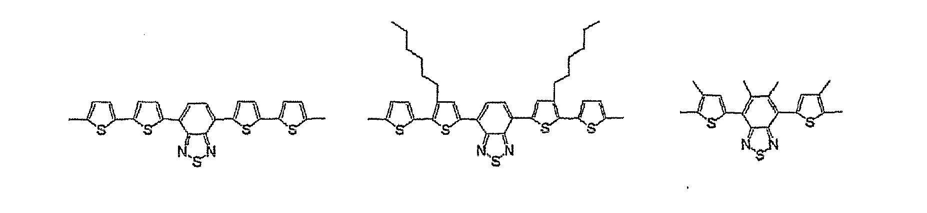

The polymer to be used in the present invention may contain one kind or two or more kinds of structures represented by formula (2).

Among the repeating units each of which is composed of the structure represented by formula (1) and the structure represented by formula (2), a preferable unit is composed of one or more structures selected from specific examples of structures represented by the aforementioned formula (1) and one or more structures selected from specific examples of structures represented by the aforementioned formula (2).

Among the repeating units each of which is composed of the Structure represented by formula (1) and the Structure represented by formula (2), the repeating unit represented by formula (3) is preferably used. 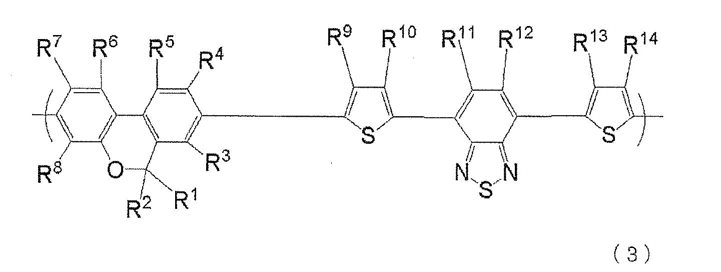 (wherein, R¹ to R¹⁴ have the same meanings described above.)

In formula (3), each of R⁹ to R¹⁴ is preferably a hydrogen atom.

Examples of the polymer to be used in the present invention include the following polymers: 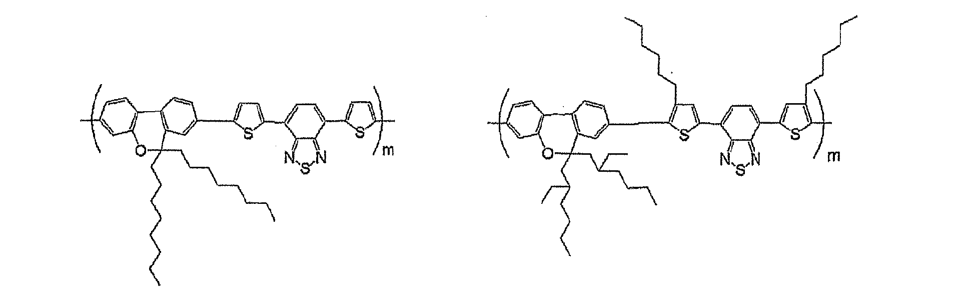 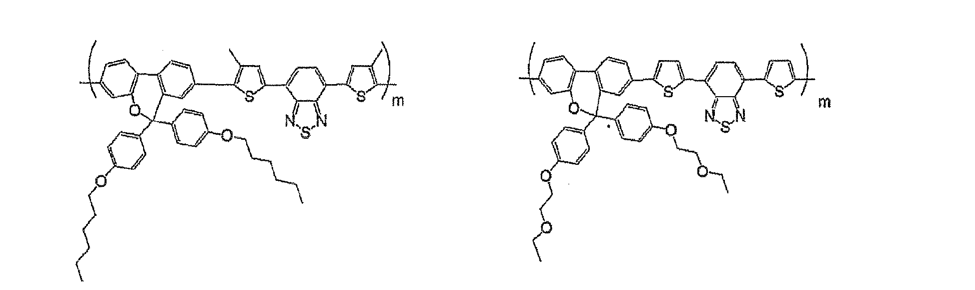 (wherein, m represents the number of repeating unit.)

In the polymer to be used in the present invention, the repeating unit, composed of the structure represented by formula (1) and the structure represented by formula (2), are preferably in a range from 20 to 100 mole% relative to the sum of the total repeating units in the polymer, and in order to obtain a high photoelectric conversion efficiency, this range is preferably set to 50 to 100 mole%.

The polymer used for the present invention has high absorbance, and efficiently absorbs solar light so that an organic photoelectric conversion element manufactured by using the polymer is allowed to have a high short circuit current density.

The polymer to be used in the present invention preferably has a polystyrene-conversion weight average molecular weight in a range of from 10³ to 10⁸, more preferably from 10³ to 10⁷, much more preferably from 10³ to 10⁶.

When the polymer of the present invention is used for producing an organic photoelectric conversion element, polymerization active groups remaining at the terminal, which are derived from the material monomer or the like of the polymer, may cause the durability and the like of the resultant element to lower. Therefore, it is preferable to protect the terminal by using a stable group.

Each of the stable group for use in protecting the terminal include an alkyl group, an alkoxy group, a fluoroalkyl group, a fluoroalkoxy group, an aryl group, an arylamino group and a monovalent heterocyclic group. In place of using the stable group, a hydrogen atom may be placed at the terminal. In order to improve a hole-transporting characteristic by the terminal, an electron-donating group, such as the arylamino group, is preferably used. Preferable terminal groups are those having continuous conjugated bonds with a conjugated structure of a main chain, for example, a group that is bonded to an aryl group or a monovalent heterocyclic group via a carbon-carbon bond. Examples of the arylamino group include a phenylamino group and a diphenylamino group. Examples of the monovalent heterocyclic group include a thienyl group, a pyrrolyl group, a furyl group, a pyridyl group, a piperidyl group, a quinolyl group and an isoquinolyl group.

The polymer to be used in the present invention is preferably a conjugated polymer compound. The conjugated polymer compound means a compound in which main chains of molecules forming the compound are essentially conjugated with each other.

### <Production Method of Polymer>

The polymer to be used in the present invention may be produced by using any method, and for example, this is produced by a polymerization method using a known aryl-aryl coupling process using alkali, an appropriate catalyst, a ligand and the like, after a monomer having a functional group suitable for a polymerization reaction to be used is prepared and it is dissolved in an organic solvent if necessary. The above-mentioned monomer can be produced by reference to, for example, a method described in JP-A No. 2006-182920, JP-A No. 2006-335933, etc.

Examples of the polymerization method using the aryl-aryl coupling process include the following (1) to (5) methods:

### (1) Method for polymerizing by using Suzuki coupling reaction

A monomer having boric acid residues or borate ester residues and a monomer having a halogen atom, such as a bromine atom, an iodine atom and a chlorine atom, or a sulfonate group, such as a trifluoromethanesulfonate group and a p-toluenesulfonate group, are polymerized in the presence of an inorganic base such as sodium carbonate, potassium carbonate, cesium carbonate, potassium triphosphate, and potassium fluoride, or an organic base such as tetrabutylammonium fluoride, tetrabutylammonium chloride, tetrabutylammonium bromide, and tetraethylammonium hydroxide, by using a catalyst composed of a palladium complex or a nickel complex such as palladium [tetrakis(triphenylphosphine)]; [tris(dibenzylideneacetone)]dipalladium, palladium acetate, bis(triphenylphosphine)palladium dichloride and bis(cyclooctadiene)nickel, and if necessary, further a ligand such as triphenylphosphine tri(2-metylphenyl), tri(2-methoxyphenyl)phosphine, diphenylphosphinopropane, tri(cyclohexyl)phosphine, and tri(tert-butyl)phosphine.

### (2) Method for polymerizing by using Yamamoto coupling reaction

Monomers having a halogen atom or a sulfonate group such as trifluoromethanesulfonate are mutually reacted with each other by using a catalyst composed of a nickel zero-valent complex such as bis (cyclooctadiene) nickel and a ligand such as bipyridyl, or a catalyst composed of a nickel complex, such as [bis(diphenylphosphino)ethane]nickel dichloride, [bis(diphenylphosphino)propane]nickel dichloride, and, if necessary, a ligand such as triphenylphosphine, diphenylphosphinopropane, tri(cyclohexyl)phosphine, tri(tert-butyl)phosphine, as well as a reducing agent such as zinc and magnesium, if necessary, under a dehydration condition.

### (3) Method for polymerizing by using Kumada-Tamao coupling reaction

A compound having a halogenated magnesium group and a compound having a halogen atom are allowed to be polymerized by a process of an aryl coupling reaction in which a nickel catalyst such as [bis(diphenylphosphino)ethane]nickel dichloride, and [bis(diphenylphosphino)propane]nickel dichloride is used as a catalyst under a dehydration condition.

### (4) Method for polymerizing by the use of an oxidizing agent such as FeCl₃

### (5) Method for oxidation-polymerizing electrochemically

In the polymerization method using the aryl-aryl coupling, usually, a solvent is used. The solvent is preferably selected by taking a polymerization reaction to be used and solubility and the like of the monomer and the polymer into consideration. Specific examples thereof include an organic solvent such as tetrahydrofran, toluene, 1,4-dioxane, dimethoxyethane, N,N-dimethylacetamide, N,N-dimethylformamide and a mixed solvent of two or more kinds of these, or a two-phase system of these and water. In Suzuki coupling reaction, preferable examples include an organic solvent such as tetrahydrofran, toluene, 1,4-dioxane, dimethoxyethane, N,N-dimethylacetamide, N,N-dimethylformamide and a mixed solvent of two or more kinds of these, or a two-phase system of these and water. In general, the reaction solvent is preferably subjected to a deoxidation process so as to suppress side reactions. In Yamamoto coupling reaction, preferable examples of the solvents include an organic solvent such as tetrahydrofran, toluene, 1,4-dioxane, dimethoxyethane, N,N-dimethylacetamide, N,N-dimethylformamide and a mixed solvent of two or more kinds of these. In general, the reaction solvent is preferably subjected to a deoxidation process so as to suppress side reactions.

Among the above-mentioned polymerization methods by using the aryl-aryl coupling, Suzuki coupling reaction and Yamamoto coupling reaction are preferably used from the viewpoint of reactivity. Further, Yamamoto coupling reaction in which a nickel zero-valent complex is utilized or Suzuki coupling reaction is more preferably used. More specifically, the polymerization by the use of Suzuki coupling can be referred to a known method described in Journal of Polymer Science, Part A, Polymer Chemistry, Vol. 39, 1533-1556 (2001). The polymerization by the use of Yamamoto coupling can be referred to a known method described in Macromolecules 1992, 25, 1214-1223.

In the polymerization method by using the aryl-aryl coupling, the reaction temperature is not particularly limited, as long as it is in such a temperature range as to maintain the reaction solution in a liquid state. The lower limit thereof is preferably -100°C, more preferably -20°C, much more preferably 0°C in the viewpoint of reactivity, and the upper limit thereof is preferably 200°C, more preferably 150°C, much more preferably 120°C in the viewpoint of stability.

In the polymerization reaction by using the aryl-aryl coupling, an isolation process of the polymer of the present invention from the reaction mixture after completion of the reaction may be carried out by using a known method. For example, the reaction solution is added to a lower alcohol such as methanol, and precipitate is filtrated and dried to obtain the polymer of the present invention. When the resultant polymer has a low purity, it can be purified by using a usual method, such as recrystallization, continuous extraction by using a Soxhlet extractor, column chromatography, and so on.

### <Organic Photoelectric Conversion Element>

The organic photoelectric conversion element of the present invention comprises a pair of electrodes and a functional layer placed between the electrodes, and the functional layer has a polymer containing a repeating unit that is composed of a structure represented by formula (1) and a structure represented by formula (2), and examples thereof include:
1. an organic photoelectric conversion element comprising a pair of electrodes, and a functional layer and an organic layer that are placed between the electrodes, and the organic layer has an electron-accepting compound, and the functional layer has a polymer containing a repeating unit that is composed of a structure represented by formula (1) and a structure represented by formula (2), wherein the organic layer and the functional layer being made in contact with each other;
2. an organic photoelectric conversion element comprising a pair of electrodes, and a functional layer placed between the electrodes, and the functional layer has an electron-accepting compound and a polymer containing a repeating unit that is composed of a structure represented by formula (1) and a structure represented by formula (2); and
3. an organic photoelectric conversion element comprising a pair of electrodes, and a functional layer placed between the electrodes, and the functional layer has an electron-accepting compound and a polymer containing a repeating unit that is composed of a structure represented by formula (1) and a structure represented by formula (2), and the electron-accepting compound is a fullerene derivative. The paired electrodes are usually designed so that at least one of them is transparent or translucent. The following description will explain this structure.

In the organic photoelectric conversion element of the above-mentioned2, the ratio of the electron-accepting compound in the functional layer containing the electron-accepting compound and the polymer having the structure represented by formula (1) is preferably 10 to 1000 parts by weight relative to 100 parts by weight of the polymer.

In the organic photoelectric conversion element of the above-mentioned 3, the ratio of the fullerene derivative in the functional layer containing the fullerene derivative and the polymer is preferably 10 to 1000 parts by weight, more preferably 20 to 500 parts by weight, relative to 100 parts by weight of the polymer. In order to improve the photoelectric conversion efficiency, the ratio of the fullerene derivative in the functional layer is preferably 20 to 400 parts by weight, more preferably 40 to 250 parts by weight, much more preferably to 80 to 120 parts by weight, relative to 100 parts by weight of the polymer. In order to increase the short circuit current density, the ratio of the fullerene derivative in the functional layer is preferably 20 to 250 parts by weight, more preferably 40 to 120 parts by weight, relative to 100 parts by weight of the polymer.

The following description will explain the operation mechanism of the organic photoelectric conversion element. Optical energy incident through the transparent or translucent electrode is absorbed by the electron-accepting compound and/or electron-donating compound to generate an exciton in which an electron and a hole are combined with each other. When the generated exciton is transported to reach a heterojunction interface on which the electron-accepting compound and/or electron-donating compound are placed adjacent to each other, the electron and the hole are separated from each other due to a difference between HOMO energy and LUMO energy on the interface, so that charges (electron and hole) that can move independently are generated. The charges thus generated are moved to the respective electrodes so that electric energy (electric current) can be externally taken out.

In the organic photoelectric conversion element in the present invention, the polymer containing a repeating unit having a structure represented by formula (1) and a structure represented by formula (2) usually functions as an electron-donating compound.

In order to allow the organic photoelectric conversion element to exert a high photoelectric conversion efficiency, the following structures are preferably prepared in which the electron-accepting compound and the electron-donating compound have absorbing ranges that can efficiently absorb spectra of desired incident light, many heterojunction interfaces are included so as to allow the heterojunction interfaces to efficiently separate excitons, and a desirable charge-transporting characteristic that can transport charges generated by the heterojunction interfaces swiftly to the electrodes is prepared.

In these viewpoints, the structures of the aforementioned 2 and 3 are preferably used as the organic photoelectric conversion element of the present invention, and in the viewpoint of many heterojunction interfaces included therein, the structure of the aforementioned 3 is preferably used. In the organic photoelectric conversion element of the present invention, an additional layer may be formed between at least one of the electrodes and the functional layer or the organic layer in the element. Examples of the additional layer include a charge-transporting layer used for transporting holes or electrons and a buffer layer.

The organic photoelectric conversion element of the present invention is usually formed on a substrate. This substrate is preferably formed by a material that is not deformed even when electrodes and a layer of an organic substance are formed thereon. Examples of the material for the substrate include glass, plastics, a polymer film and silicon. When the substrate is opaque, the electrode on the opposite side (that is, the electrode farther from the substrate) is preferably made transparent or translucent.

Examples of the material for the transparent or translucent electrode include a conductive metal oxide film and a translucent metal thin film. More specifically, a film (NESA or the like), formed by using a conductive material such as indium oxide, zinc oxide, tin oxide, and indium-tin-oxide (ITO) and indium-zinc-oxide that are composites of these is used. Further, gold, platinum, silver, copper and the like, are also used. ITO, indium-zinc-oxide and zinc oxide are preferably used.

An organic transparent conductive film such as polyaniline and a derivative thereof, and polythiophene and a derivative thereof may be used as a material for the transparent or translucent electrode.

Moreover, as the electrode material, metal, a conductive polymer, or the like may be used. One electrode of the paired electrodes is preferably made of a material having a small work function. Examples of this electrode material include metals, such as lithium, sodium, potassium, rubidium, cesium, magnesium, calcium, strontium, barium, aluminum, scandium, vanadium, zinc, yttrium, indium, cerium, samarium, europium, terbium, and ytterbium, and alloys of two or more kinds of these, or alloys of one or more of these and one or more of gold, silver, platinum, copper, manganese, titanium, cobalt, nickel, tungsten and tin, and graphite or a graphite interlayer compound.

Examples of the alloy include magnesium-silver alloy, magnesium-indium alloy, magnesium-aluminum alloy, indium-silver alloy, lithium-aluminum alloy, lithium-magnesium alloy, lithium-indium alloy and calcium-aluminum alloy.

One of the paired electrodes forms the anode (positive electrode in a solar battery), and the other forms the cathode (negative electrode in the solar battery).

Examples of the method forming the electrodes include a vacuum vapor deposition method, a sputtering method, an ion plating method and a plating method.

As the functional layer (functional layer containing the polymer used in the present invention) in the organic photoelectric conversion element of the present invention, for example, an organic thin film containing the polymer used in the present invention may be used.

The organic thin film usually has a film thickness from 1 nm to 100 µm, preferably from 2 nm to 1000 nm, more preferably from 5 nm to 500 nm, much more preferably from 20 nm to 200 nm.

The organic thin film may contain only one kind of the polymers, or may contain two or more kinds of them in combination. In order to improve the hole-transporting characteristic of the organic thin film, a low molecular weight compound and/or a polymer other than the above-mentioned polymers may be mixed in the organic thin film to be used as the electron-donating compound and/or electron-accepting compound.

Examples of the electron-donating compound, in addition to the polymer used in the present invention, include pyrazoline derivatives, arylamine derivatives, stilbene derivatives, triphenyldiamine derivatives, oligothiophene and derivatives thereof, polyvinylcarbazole and derivatives thereof, polysilane and derivatives thereof, polysiloxane derivatives having aromatic amine in the side chain or main chain thereof, polyaniline and derivatives thereof, polythiophene and derivatives thereof, polypyrrole and derivatives thereof, polyphenylenevinylene and derivatives thereof and polythienylenevinylene and derivatives thereof.

Examples of the electron-accepting compound include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof diphonoquinone derivatives, 8-hydroxyquinoline and metal complexes of derivatives thereof, polyquinoline and derivatives thereof, polyquinoxaline and derivatives thereof, polyfluorene and derivatives thereof, fullerenes of C₆₀ and the like and derivatives thereof, and phenanthrene derivatives, such as 2,9-dimethyl-4,7-diphenyl-1,10-phenanthroline in addition to the polymer used in the present invention. Among these, fullerenes and derivatives thereof are preferably used.

Additionally, the electron-donating compound and the electron-accepting compound are relatively determined based upon the energy level of these compounds.

As the fullerenes, C₆₀, C₇₀, carbon nanotube, and derivatives thereof are used. Specific examples of derivatives of C₆₀ include the following compounds:

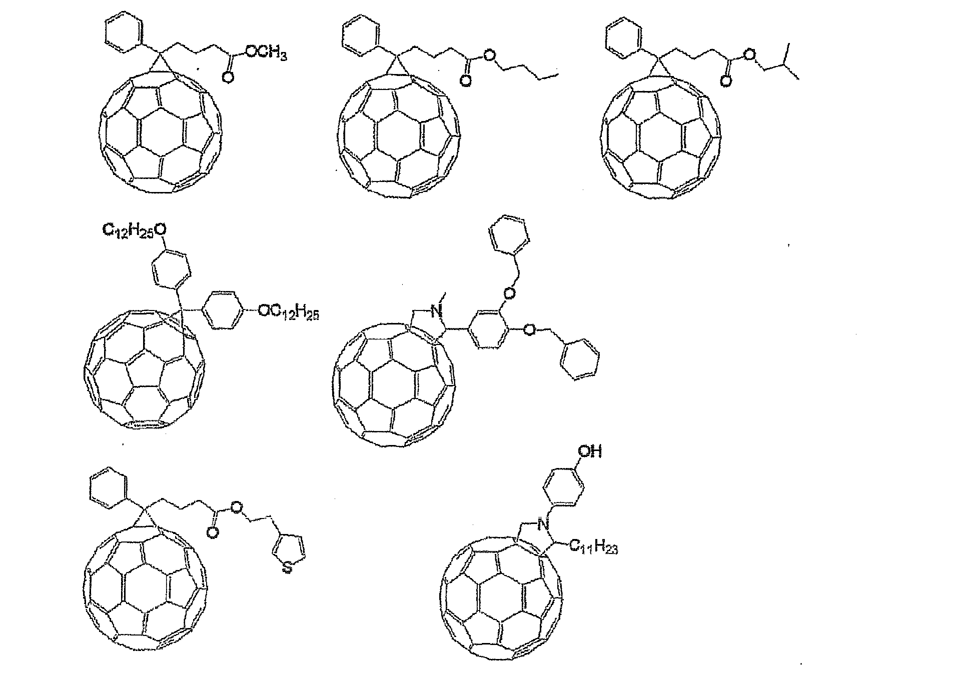

The above-mentioned organic thin film may be produced by using any method, and, for example, a film forming method from a solution containing the polymer used in the present invention may be used, or the solution may be formed into a thin film by using a vacuum vapor deposition method.

A solvent to be used for forming the film from the solution is not particularly limited as long as it can dissolve the polymer used in the present invention. Examples of the solvent include unsaturated hydrocarbon solvents such as toluene, xylene, mesitylene, tetralin, decalin, bicyclohexyl, n-butylbenzene, sec-butylbenzene and tert-butylbenzene; halogenated saturated hydrocarbon solvents such as carbon tetrachloride, chloroform, dichloromethane, dichloroethane, chlorobutane, bromobutane, chloropentane, bromopentane, chlorohexane, bromohexane, chlorocyclohexane and bromocyclohexane; halogenated unsaturated hydrocarbon solvents such as chlorobenzene, dichlorobenzene and trichlorobenzene; and ether sol vents such as tetrahydrofran and tetrahydropyran. The polymer to be used in the present invention is usually dissolved in the solvent at a rate of 0.1% by weight or more.

As the film forming method from a solution, there can be used coating methods such as a spin coating method, casting method, micro gravure coating method, gravure coating method, bar coating method, roll coating method, wire bar coating method, dip coating method, spray coating method, screen printing method, flexo printing method, offset printing method, inkjet printing method, dispenser printing method, nozzle coating method, capillary coating method and the like. Among these, the spin coating method, flexo printing method, inkjet printing method and dispenser printing method are preferably used.

When the photoelectric conversion element of the present invention has an organic layer placed adjacent to the functional layer, which contains the electron-accepting compound, the film thickness of the organic layer is usually 1 nm to 100 µm, preferably 2 nm to 1000 nm, more preferably 5 nm to 50 nm, much more preferably 20 nm to 200 nm.

The organic layer may contain components other than the electron-accepting compound.

As the components other than the electron-accepting compound, a binder component and the like are proposed.

The content of the electron-accepting compound in the organic layer is usually 1% by weight or more and 100% by weight of less.

The organic layer may be formed by using the same method as the method for forming the organic thin film serving as a functional layer. The organic layer is preferably disposed on the cathode side (negative electrode in a solar battery).

The photoelectric conversion element of the present invention may have additional layers other than the paired electrodes, functional layer and organic layer.

Examples of the additional layers include a charge-transporting layer and a buffer layer.

The charge-transporting layer is preferably formed between the paired electrodes so as to be adjacent to the functional layer or the organic layer.

The buffer layer is preferably formed between the paired electrodes so as to be adjacent to the electrodes.

The aforementioned electron-donating compound and electron-accepting compound may be used as a material used for the charge-transporting layer, that is, a hole-transporting layer and an electron-transporting layer, which is the additional layer.

As a material used for the buffer layer serving as the additional layer, halide and oxide of alkali metal and alkali earth metal such as lithium fluoride may be used. Fine particles of an inorganic semiconductor, such as titanium oxide, may also be used.

When the organic photoelectric conversion element is irradiated with light such as solar light from the transparent or translucent electrode side, a photo-electromotive force is generated between the electrodes, so that it can be operated as an organic thin-film solar battery. By integrating a plurality of organic thin-film solar batteries, an organic thin-film solar battery module can be formed and utilized.

When irradiated with light from the transparent or translucent electrode side, with a voltage being applied between the electrodes, a photoelectric current is allowed to flow, so that the element can be operated as an organic photosensor. By integrating a plurality of organic photosensors, an organic image sensor may be formed and utilized.

### <Applications of Element>

By integrating a plurality of the organic photoelectric conversion elements of the present invention, an organic thin-film solar battery module and an organic image sensor can be formed.

### EXAMPLES

The following description will show examples so as to explain the present invention in detail. However, the present invention is not limited to these.

The polystyrene-conversion weight average molecular weight was obtained by using a size exclusion chromatography (SEC) .

Column: TOSOH TSKgel SuperHM-H (two sets) + TSKgel SuperH2000 (4.6 mm I.d. × 15 cm); Detector: RI (SHIMADZU RID-10A); Mobile Phase: Tetrahydrofran (THE)

### <Synthesis Example 1>

### (Synthesis of Compound (A))

To a 500 ml three-neck flask whose inside atmosphere was replaced with nitrogen, 2,7-dibromo-9-fluorene (6.65 g) was charged and dissolved in a mixed solvent (140 ml) of trifluoroacetic acid: chloroform = 1 : 1 (weight standard). To the resultant solution, sodium perborate monohydrate was added, and stirred for 20 hours. The reaction solution was filtrated with Celite, and washed with toluene. The resultant filtrate was washed with water, sodium hydrogen sulfite and saturated saline solution in this order, and then dried over sodium sulfate. The solvent was distilled off to give a crude product (6.11 g).

The crude product was recrystallized by using toluene, and again further recrystallized by using chloroform to obtain a compound (A-1) (1.19 g) represented by the following formula.

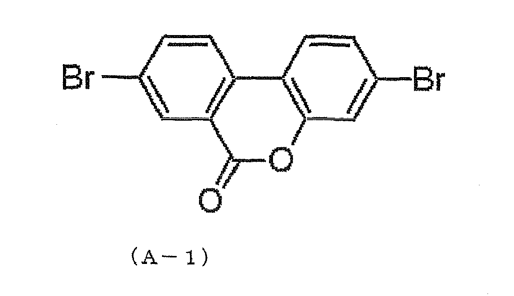

### • Preparation of C₈H₁₇MgBr

To a 100 ml three-neck flask, magnesium (1.33g) was charged, and the flask was heated by using a heat gun, and its inside atmosphere was replaced with argon. Tetrahydrofran (10 ml) and 1-bromooctane (2.3 ml) were added thereto, and heated to start a reaction. The mixture was refluxed for 2.5 hours, and then allowed to stand to be cooled down to room temperature to obtain a solution of C₈H₁₇MgBr.

### • Grignard Reaction

To a 300 ml three-neck flask whose inside atmosphere was replaced with nitrogen, compound (A-1) (1.00 g) was charged and suspended in 10 ml of tetrahydrofuran. This was cooled to 0°C, and the C₈H₁₇MgBr solution prepared as described above was added thereto. After removing the cold bath, the mixture was stirred for 5 hours under reflux. The reaction solution was allowed to stand to be cooled, and then 10 ml of water and 5 ml of hydrochloric acid were added thereto. The suspension, kept in this state prior to the addition of hydrochloric acid, was formed into a solution of two phases after the addition. After a phase separation, the organic phase was washed with water and a saturated saline solution in this order. The organic phase thus obtained was dried over sodium sulfate, and the solvent was distilled off to give 1.65 g of a crude product, which was purified by a silica gel column chromatography (hexane : ethyl acetate = 20 _{:} 1 (volume standard) to obtain a compound (A-2)(1.30 g) represented by the following formula.

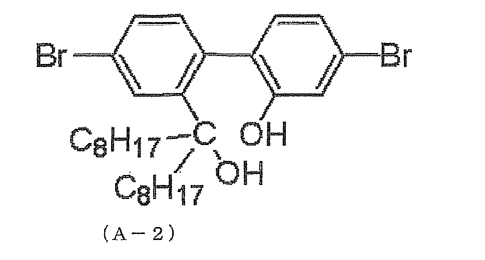

To a 25 ml two-neck flask whose inside atmosphere was replaced with nitrogen, compound (A-2) (0.20 g) was charged and dissolved in 4 ml of toluene. To this solution, p-toluene sulfonic acid monohydrate (0.02g (0.06mmol)) was added, and stirred for 11 hours at 100°C. The resultant reaction solution was allowed to stand to be cooled, and then washed with water, an aqueous solution of 4N sodium hydroxide, water and a saturated saline solution in this order. The solvent was distilled off to obtain a compound (A-3)(0.14 g) represented by the following formula.

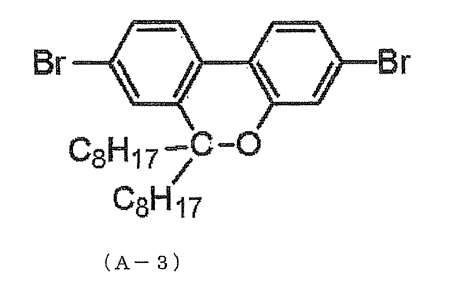

To a reaction vessel under nitrogen atmosphere, compound (A-3)(1.0g (1.77 mmol)), bis (pinacolate) diboron (0.945g (3. 72 mmol)), [1,1'-bis (diphenylphosphino) ferrocene] palladium dichloride (0.078 g (0.11 mmol)), 1,1'-bis (diphenylphosphino)ferrocene (0.059 g (0.11 mmol), and 1.4-dioxane (15 ml) were added, and the mixture was subjected to a bubbling process with an argon gas for 30 minutes. Thereafter, potassium acetate (1.043 g (10.6 mmol) was added thereto, and allowed to react under nitrogen atmosphere at 95°C for 13.5 hours. After the reaction, the resultant reaction solution was filtrated to remove insoluble materials. The filtrate was purified by using an alumina short column. After removing the solvent, the solid components were dissolved in toluene, to which activated carbon was added, stirred and then filtrated. The resultant filtrate was purified by an alumina short column again, and activated carbon was added thereto, stirred and then filtrated. After removing toluene completely from the resultant filtrate, hexane (2.5 ml) was added thereto to be recrystallized to obtain a compound (A)(0.28 g), represented by the following formula.

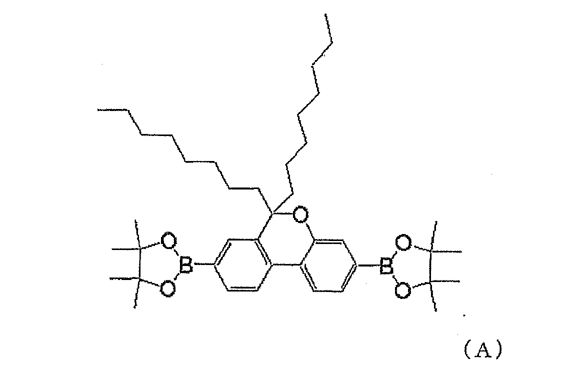

### <Synthesis Example 2>

### (Synthesis of Polymer Compound 1)

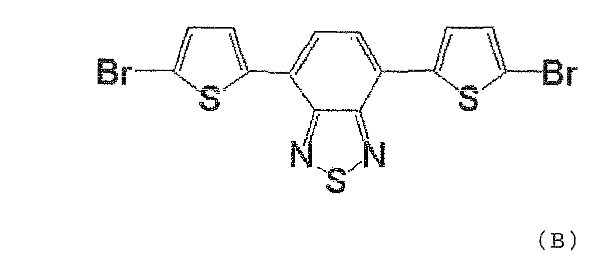

To a reaction vessel, compound (A)(0.660 g), compound (B) (0.504 g), methyltrioctylammonium chloride (trade name: aliquat336, made by Aldrich Chemical Co., CH₃N[(CH₂)₇CH₃]₃ Cl, density: 0.884 g/ml, 25°C, (registered trademark))(0.29 g), palladium (II) acetate (2.9 mg) and tris(2-methoxyphenyl)phosphine (14.4 mg) were added, and the inside atmosphere of the reaction vessel was sufficiently replaced with an argon gas. To this reaction vessel, toluene (50 g) that had been preliminarily degassed by bubbling argon was added. Then, 5 ml of an aqueous solution of sodium carbonate (16.7% by weight) that had been preliminarily degassed by bubbling argon was dropped to this solution, and the resultant solution was heated to a temperature at which the solvent was refluxed, and was refluxed for 6.5 hours. The reaction was carried out under argon gas atmosphere.

Then, the reaction solution was cooled and a solution of phenylborate (0.23 g) /tetrahydrofran (1.0 ml) was added to this reaction solution. The resultant solution was heated and refluxed for 6.5 hours. The reaction was carried out under argon gas atmosphere.

After the reaction, the reaction solution was cooled to near room temperature, and the resultant reaction solution was then allowed to stand still and a toluene layer in the separated solution was collected. Then, the resultant toluene layer was poured into methanol for reprecipitation, and the generated precipitate was collected. After drying the precipitate under reduced pressure, it was dissolved in chloroform. The resultant chloroform solution was filtrated so that the insoluble matters were removed, and was then purified through an aluminum column. After a concentration under reduced pressure, the resultant chloroform solution was poured into methanol for reprecipitation, and the generated precipitate was collected. The precipitate was washed with methanol, and then dried under reduced pressure to obtain a polymer compound 1 (0.24 g).

### <Synthesis Example 3>

### (Synthesis of Polymer Compound 2)

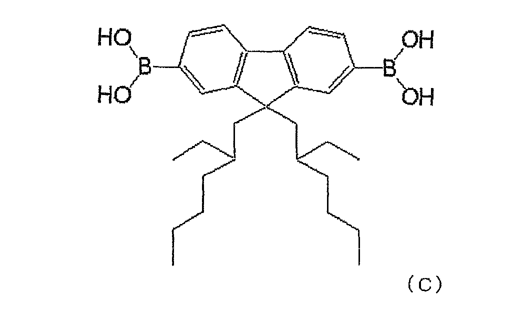

To a reaction vessel, compound (C)(0.480 g), compound (B) (0.504 g), methyltrioctylammonium chloride (trade name: aliquat336, made by Aldrich Chemical Co., CH₃N[(CH₂)₇CH₃]₃ Cl, density: 0.884 g/ml, 25°C, (registered trademark)) (0.27 g), palladium (II) acetate (2.5 mg) and tris(2-methoxyphenyl)phosphine (14.6mg) were charged, and the inside atmosphere of the reaction vessel was sufficiently replaced with an argon gas. To this reaction vessel, toluene (50 g) that had been preliminarily degassed by bubbling argon was added. Then, 5 ml of an aqueous solution of sodium carbonate (16.7% by weight) that had been preliminarily degassed by bubbling argon was dropped to this solution, and the resultant solution was heated to a temperature at which the solvent was refluxed, and was refluxed for 6.5 hours. The reaction was carried out under argon gas atmosphere.

Then, the reaction solution was cooled, and a solution of phenylborate (0.23 g)/tetrahydrofran (1.0 ml) was added to this reaction solution. The resultant solution was heated, and refluxed for 6.5 hours. The reaction was carried out under argon gas atmosphere.

After the reaction, the reaction solution was cooled to near room temperature, and the resultant reaction solution was allowed to stand still and a toluene layer in the separated solution was collected. Then, the resultant toluene layer was poured into methanol for reprecipitation, and the generated precipitate was collected. After drying under reduced pressure, the resultant precipitate was dissolved in chloroform. The resultant chloroform solution was filtrated so that the insoluble matters were removed, and then purified through an aluminum column. After a concentration under reduced pressure, the resultant chloroform solution was poured into methanol for reprecipitation, and the generated precipitate was collected. The precipitate was washed with methanol, and then dried under reduced pressure to obtain a polymer compound (0.11 g)(hereinafter, referred to as "polymer compound 2").

### <Synthesis Example 4>

### (Synthesis of Polymer Compound 3)

To a reaction vessel, compound (A)(1.184 g), compound (B) (0.871 g), methyltrioctylammonium chloride (trade name: aliquat336, made by Aldrich Chemical Co., CH₃N[(C_{H2})₇CH₃]₃ Cl, density: 0.884 g/ml, 25°C, (registered trademark)) (0.52 g), and palladium (II) dichlorobis(triphenylphosphine)(3.0 mg) were charged, and the inside atmosphere of the reaction vessel was sufficiently replaced with an argon gas. To this reaction vessel, 1,4-dioxane (80 g) that had been preliminarily degassed by bubbling argon was added. Then, 10 ml of an aqueous solution of sodium carbonate (16.7% by weight) that had been preliminarily degassed by bubbling argon was dropped to this solution, and the resultant solution was heated to a temperature at which the solvent was refluxed, and was refluxed for 6.5 hours.

The reaction was carried out under argon gas atmosphere.

Then, after completion of the reaction, the reaction solution was cooled to near room temperature, and then the resultant reaction solution was filtrated so that the precipitate was collected. Then, the precipitate thus obtained was washed with methanol, and the resultant precipitate was dried under reduced pressure. The resultant precipitate was dissolved in chloroform. The resultant chloroform solution was filtrated, and the filtrate was purified through an aluminum column. Then, the resultant chloroform solution was poured into methanol for reprecipitation, and the generated precipitate was collected. The precipitate was washed with methanol, and then dried under reduced pressure to obtain a polymer (0.43 g)(hereinafter, referred to as "polymer compound 3").

The polymer compound 3 had a polystyrene-conversion weight average molecular weight of 6.3 × 10⁴ and a polystyrene-conversion number average molecular weight of 4.2 × 10³.

### <Example 1>

### (Production of Organic Thin-Film Solar Battery, Evaluation)

A fullerene derivative (C60PCBM(Phenyl C61-butyric acid methyl ester, trade name: E100, made by Frontier Carbon Cooperation)) and the polymer compound 1 serving as an electron-donating compound were dissolved in o-dichlorobenzene so as to be set to 3 _{:} 1 (weight ratio) at a concentration of 2% by weight. The resultant solution was filtrated through a Teflon (registered trademark) filter having a pore diameter of 1.0 µm to prepare a coating solution 1.

A surface treatment was carried out by an ozone UV treatment of a glass substrate with an ITO film having a thickness of 150 nm formed by a sputtering method. Then, the coating solution 1 was applied thereto by using a spin coating method to obtain a functional film (film thickness: 100 nm) of an organic thin-film solar battery. Thereafter, lithium fluoride was vapor deposited thereon with a film thickness of 4 nm by using a vacuum vapor depositing device, and aluminum was then vapor deposited thereon with a film thickness of 100 nm to produce an organic thin film solar battery. Upon carrying out vapor deposition, the degree of vacuum was 1 to 9 × 10⁻³ Pa in all the cases. The shape of the organic thin film solar battery thus obtained was a square of 2 mm × 2 mm. The Jsc (short circuit current density) of the resultant organic thin film solar battery was measured by irradiating it with constant light by using a solar simulator (trade name: OTENTO-SUN II: AM1.5G filter, irradiance: 100 mW/cm², made by BUNKOUKEIKI Co., Ltd.) By measuring a generated current and voltage, photoelectric conversion efficiency was found. Table 1 shows the results thereof.

### <Example 2>

### (Production of Organic Thin-Film Solar Battery, Evaluation)

C60PCBM(trade name: E100H, made by Frontier Carbon Corporation) and the polymer compound 1 were dissolved in o-dichlorobenzene so as to be set to 2 _{:} 1 (weight ratio) at a concentration of 1.5% by weight. Thereafter, silica gel (Wakogel C-300 (particle size 45 to 75 µm) made by Wako Pure Chemical Industries, Ltd.) was added to the resultant solution at 1% by weight relative to the weight of the solution, and stirred at 23°C for 12 hours. After completion of the stirring, the silica gel in the solution was filtrated by using a Teflon (registered trademark) filter having a pore diameter of 1.0 µm to prepare a coating solution 2.

The same processes as those of example 1 were carried out, except that the coating solution 2 was used in place of the coating solution 1, to produce an organic photoelectric conversion element. The film thickness of the functional layer was about 100 nm. Values of the short circuit current density and the photoelectric conversion efficiency were shown in Table 1.

### <Example 3>

### (Production of Organic Thin-Film Solar Battery, Evaluation)

C60PCBM(trade name: E100H, made by Frontier Carbon Corporation) and the polymer compound 1 were dissolved in o-dichlorobenzene so as to be set to 1 _{:} 1 (weight ratio) at a concentration of 2% by weight. Thereafter, silica gel (Wakogel C-300 (particle size 45 to 75 µm) made by Wako Pure Chemical Industries, Ltd.) was added to the resultant solution at 1% by weight relative to the weight of the solution, and stirred at 23°C for 12 hours. After completion of the stirring, the silica gel in the solution was filtrated by using a Teflon (registered trademark) filter having a pore diameter of 1.0 µm to prepare a coating solution 3.

The same processes as those of example 1 were carried out, except that the coating solution 3 was used in place of the coating solution 1, to produce an organic photoelectric conversion element. The film thickness of the functional layer was about 100 nm. Values of the short circuit current density and the photoelectric conversion efficiency were shown in Table 1.

### <Example 4>

### (Production of Organic Thin-Film Solar Battery, Evaluation)

C60PCBM(trade name: E100H, made by Frontier Carbon Corporation) and the polymer compound 1 were dissolved in o-dichlorobenzene so as to be set to 0.5 : 1 (weight ratio) at a concentration of 1.5% by weight. Thereafter, silica gel (Wakogel C-300 (particle size 45 to 75 µm) made by Wako Pure Chemical Industries, Ltd.) was added to the resultant solution at 1% by weight relative to the weight of the solution, and stirred at 23°C for 12 hours. After completion of the stirring, the silica gel in the solution was filtrated by using a Teflon (registered trademark) filter having a pore diameter of 1.0 µm to prepare a coating solution 4.

The same processes as those of example 1 were carried out, except that the coating solution 4 was used in place of the coating solution 1, to produce an organic photoelectric conversion element. The film thickness of the functional layer was about 100 nm. Values of the short circuit current density and the photoelectric conversion efficiency were shown in Table 1.

### <Example 5>

### (Production of Organic Thin-Film Solar Battery, Evaluation)

The same processes as those of example 1 were carried out, except that the polymer compound 1 in example 1 was replaced by the polymer compound 3, to produce an organic thin film solar battery, and evaluated. The results thus obtained are shown in Table 1.

### <Measuring Example 1>

The coating solution 1 was applied onto a glass substrate by using a spin coating method to form a thin film having a thickness of 100 nm. Measurements were carried out by using an ultraviolet-visible near-infrared spectrophotometer (V-600, made by JASCO Corporation) . The peak of absorption in a range from 500 to 700 nm was 570 nm and the absorbance at this time was 0.33.

### <Comparative Example 1>

The same processes as those of example 1 were carried out, except that the polymer compound 1 in example 1 was replaced by the polymer compound 2, to produce an organic thin film solar battery, and evaluated. The results thus obtained are shown in Table 1.

### <Measuring Example 2>

The same processes as those of measuring example 1 were carried out, except that the polymer compound 1 in measuring example 1 was replaced by the polymer compound 2, to produce a thin film, and its absorbance was evaluated. The peak of absorption in a range from 500 to 700 nm was 540 nm, and the absorbance at this time was 0.20.

### <Measuring Example 3>

The same processes as those of measuring example 1 were carried out, except that the polymer compound 1 in measuring example 1 was replaced by the polymer compound 3, to produce a thin film, and its absorbance was evaluated. The peak of absorption in a range from 500 to 700 nm was 565 nm, and the absorbance at this time was 0.24.

**Table 1**

| | Polymer Compound | Short Circuit Current Density (mA/cm²) | Photoelectric Conversion Efficiency (%) |
|---|---|---|---|
| Example 1 | Polymer Compound 1 | 7.5 | 2.6 |
| Example 2 | Polymer Compound 1 | 7.4 | 3.4 |
| Example 3 | Polymer Compound 1 | 8.1 | 3.9 |
| Example 4 | Polymer Compound 1 | 8.2 | 3.6 |
| Example 5 | Polymer Compound 3 | 7.1 | 3.2 |
| Comparative Example 1 | Polymer Compound 2 | 5.0 | 1.6 |

In order to provide a high performance organic photoelectric conversion element, a polymer compound having a high light absorbance is preferable used as a material for the element. As described above, the thin film formed by using the polymer compound 1 is allowed to exhibit high absorption in long wavelengths.

The organic thin film solar battery manufactured by using the polymer compound 1 is allowed to exhibit high short circuit current density and photoelectric conversion efficiency.

### INDUSTRIAL APPLICABILITY

The organic photoelectric conversion element of the present invention has a high photoelectric conversion efficiency. It is desirably used for a solar battery or an optical sensor, and effectively utilized in industrial applications.

## Claims

1. An organic photoelectric conversion element comprising:
a pair of electrodes and a functional layer placed between the electrodes, the functional layer containing an electron-accepting compound and a polymer, wherein the polymer has a repeating unit that is composed of a structure represented by formula (1) and a structure represented by formula (2): 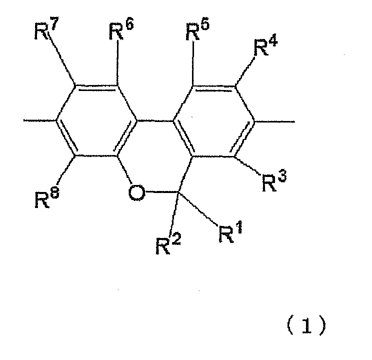 (wherein R¹ to R⁸ may be the same or different, and each represents a hydrogen atom, an alkyl group, an alkoxy group, or an optionally substituted aryl group; and a hydrogen atom contained in the groups may be substituted by a fluorine atom.) 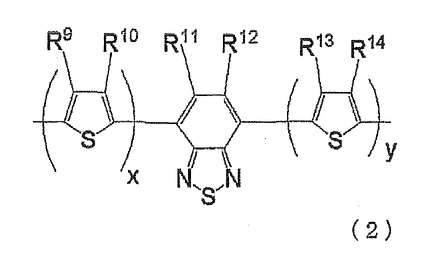 (wherein R⁹ to R¹⁴ may be the same or different, and each represents a hydrogen atom, an alkyl group, an alkoxy group, or an optionally substituted aryl group; and a hydrogen atom contained in the groups may be substituted by a fluorine atom; x and y may be the same or different, and are 1 or 2; and when there are a plurality of R⁹' s, R¹⁰' s, R¹³' s or R¹⁴' s respectively, the groups may be the same or different from each other.)

2. The organic photoelectric conversion element according to claim 1, wherein the ratio of the electron-accepting compound in the functional layer is 10 to 1000 parts by weight relative to 100 parts by weight of the polymer.

3. An organic photoelectric conversion element comprising:
a pair of electrodes; a functional layer and an organic layer that are placed between the electrodes, the organic layer containing an electron-accepting compound, wherein the functional layer contains a polymer having a repeating unit that is composed of a structure represented by formula (1) and a structure represented by formula (2), and the organic layer and the functional layer are made in contact with each other: 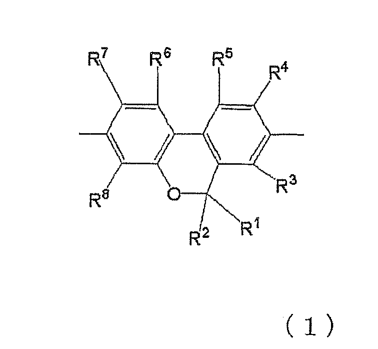 (wherein R¹ to R⁸ may be the same or different, and each represents a hydrogen atom, an alkyl group, an alkoxy group, or an optionally substituted aryl group; and a hydrogen atom contained in the groups may be substituted by a fluorine atom.) 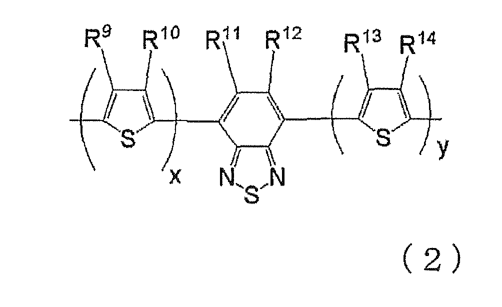 (wherein R⁹ to R¹⁴ may be the same or different, and each represents a hydrogen atom, an alkyl group, an alkoxy group, or an optionally substituted aryl group; and a hydrogen atom contained in the groups may be substituted by a fluorine atom; x and y may be the same or different, and are 1 or 2; and when there are a plurality of R⁹' s, R¹⁰' s, R¹³' s or R¹⁴' s respectively, the groups may be the same or different from each other.)

4. The organic photoelectric conversion element according to any one of claims 1 to 3, wherein the repeating unit is represented by formula (3): 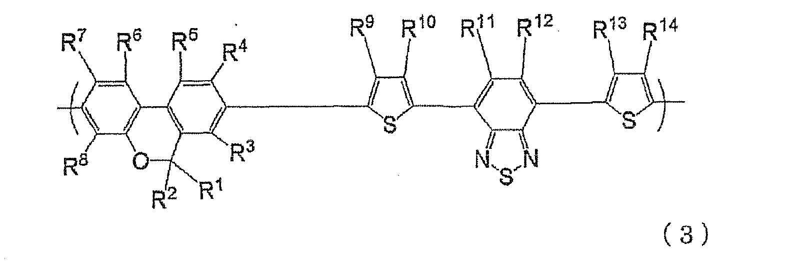 (wherein R¹ to R¹⁴ have the same meanings described above.)

5. The organic photoelectric conversion element according to any one of claims 1 to 4, wherein R⁹ to R¹⁴ are hydrogen atoms.

6. The organic photoelectric conversion element according to any one of claims 1 to 5, wherein the electron-accepting compound is a fullerene derivative.
